# EUROPEAN PATENT SPECIFICATION

(11) **EP 2 498 301 B1**
(45) Date of publication and mention of the grant of the patent: **28.08.2013**
(21) Application number: 12155700.3
(22) Date of filing: 16.02.2012
(51) Int. Cl.: H01L 31/048

(54) **Multilayered composite sheet for transparent solar panels**
Mehrschichtiger Verbund für durchsichtige Solarpanelen
Matériau composite multicouche pour pannéaux solaires transparents

(30) Priority: 10.03.2011 IT MI20110381
(43) Date of publication of application: 12.09.2012
(73) Proprietor: KOSCON INDUSTRIAL SA, 6855 Stabio (CH)
(72) Inventor: Conterno, Cosimo, 6850 MENDRISIO (CH)
(74) Representative: Giuli, Maurizio Mario Galdino

(56) References cited:
- EP-A1- 1 513 171
- US-A1- 2003 005 955
- US-A1- 2004 011 395
- US-A1- 2004 025 933

## Description

The present invention relates to a multilayered composite sheet for transparent solar panels.

The term "solar panels" relates to all devices configured for transforming solar energy into electric or thermal energy depending on the requirements.

These panels normally include photovoltaic cells or coils for the passage of water depending on whether they are photovoltaic solar panels or thermal accumulation solar panels.

Although these technologies have reached considerable energy performances and widespread use, the panels known at present have the great disadvantage of not being easily integrated with the surrounding environment.

Furthermore, as the panels currently produced are of the "blind" type which do not allow the passage of light, which is what is specifically requested, i.e. withholding as much light as possible, these panels are incompatible with buildings whose aesthetic appearance must be protected.

Furthermore, for the above characteristic of preventing the passage of light, the panels currently known are completely unsuitable for being associated with the transparent surfaces of buildings which at times, as in congress centres, sports centres or shopping centres, represent large surfaces exposed to the sun which cannot be used.

Only recently have transparent multilayered solar panels appeared on the market, of the type comprising an outer glass sheet, an internal glass sheet and a layer of transparent photovoltaic gel interposed between the glass sheets to convert solar energy into electric energy.

Not even does this solution proposed, however, which effectively allows the passage of light, solve the problems indicated above, as it is a structure which is excessively fragile, heavy and limited to a few substantially flat geometries.

These disadvantages make these known transparent multilayered solar panels unsuitable for producing transparent covering surfaces of buildings as they are difficult to lay due to their considerable weight, have a low resistance to hail due to their extreme fragility and have a poor adaptability to curved profiles often present in current coverings.

US 2004/0025933 discloses how to produce solar cells comprising a panel consisting of outer transparent sheets between which a sheet of photovoltaic material is interposed. Further sheets are also envisaged which transmit light in addition to a sheet of charge carrier material, not indicated as being transparent.

The document mainly relates to materials which form the panel with particular reference to their chemical characteristics.

Furthermore, transparent material is solely and exclusively mentioned generically, which, if glass, is extremely heavy, has a low impact strength, etc.

The documents US 2003/0005955 and US 2004/0011395 are also of the same type and mainly relate to the chemistry of solar panels and not to elements having a structure useful for producing solar panels.

An objective of the present invention is to provide a multilayered composite sheet for transparent solar panels which is capable of solving the above drawbacks of the known art in an extremely simple, economical and particularly functional manner.

A further objective is to provide a multilayered composite sheet for transparent solar panels which is extremely resistant and at the same time light and easy to produce in any geometry which is not substantially flat.

These objectives, according to the present invention, are achieved by providing a multilayered composite sheet for transparent solar panels as specified in claim 1.

Further characteristics of the invention are indicated in the dependent claims.

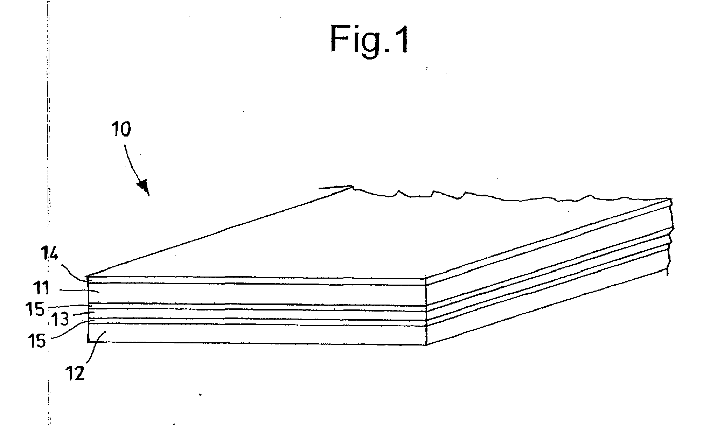

The characteristics and advantages of a multilayered composite sheet for transparent solar panels according to the present invention will appear more evident from the following illustrative and nonlimiting description, referring to the enclosed schematic drawings in which figure 1 shows, with 10, an embodiment of a multilayered composite sheet for transparent solar panels according to the present invention.

The multilayered composite sheet for transparent solar panels is of the type comprising an outer sheet 11 made of a transparent plastic material suitable for being exposed to solar light, an internal sheet 12 made of transparent plastic material and a layer of transparent photosensitive gel 13 of the type that can be activated by solar light interposed between the sheets 11, 12.

The sheets 11, 12 are preferably made of polycarbonate, a material which contemporaneously offers a high resistance and low weight.

In order to optimize the composite sheet for panels 10 and make it long-lasting with time, the presence is envisaged of a further layer of transparent anti-yellowing material 14, associated with the external side of the outer sheet, and two layers of transparent anti-hydrolysis material 15, associated with the internal sides of the sheets 11, 12.

The materials used for producing these anti-yellowing and anti-hydrolysis layers 14 and 15 are of the type currently known.

If a sheet 10 for a photovoltaic panel is requested, the transparent photosensitive gel 13 mentioned above of the type that can be activated by solar light and interposed between the sheets 11, 12, is a transparent photovoltaic gel, of the known type, configured for generating electric energy from solar light.

In this case, electrodes immersed in the photovoltaic gel are also envisaged for generating electric current.

Alternatively, if a sheet 10 for a thermal accumulation solar panel is requested, the transparent photosensitive gel 13 can be a gel having a high thermal capacity configured for accumulating thermal energy from said solar light.

In this embodiment, coils are envisaged, positioned directly in the sheets 11, 12 defining channels for the passage of a fluid configured for receiving heat from the above high-thermal-capacity gel.

In order to allow the multilayered composite sheet for transparent solar panels 10 of the present invention to be integrated with the largest possible number of structures, the transparent internal sheet 12 can be of the coloured type, on the one hand to modulate the passing light, and on the other to modify its aesthetic appearance in relation to requirements.

Again, in relation to requirements, but at the same time to increase the exposure to solar light of the transparent photosensitive gel 13, the internal side of the transparent internal sheet 12 can be of the mirrored type.

It can thus be seen that a multilayered composite sheet for transparent solar panels according to the present invention achieves the objectives indicated above.

The multilayered composite sheet for transparent solar panels of the present invention, in fact, allows the passage of light and at the same time is resistant, light and can be easily produced in any geometry which is not substantially flat.

These advantages make the multilayered composite sheet for transparent solar panels according to the present invention extremely suitable for being used as a transparent covering element for buildings, on the one hand capable of producing energy and on the other, of not modifying the aesthetical appearance of the building itself.

## Claims

1. A multilayered composite sheet for transparent solar panels (10) of the type comprising an outer sheet (11) in a transparent plastic material suitable for being exposed to solar light, an internal sheet (12) in a transparent plastic material and a layer of transparent photosensitive gel (13) of the type that can be activated by said solar light interposed between said sheets (11, 12), **characterized in that** it also envisages a further layer of transparent anti-yellowing material (14) associated with the outer side of said outer sheet and two layers of transparent anti-hydrolysis material (15) associated with the internal sides of said sheets (11, 12), isolating said layer of photosensitive gel (13).

2. The multilayered composite sheet for transparent solar panels (10) according to claim 1, **characterized in that** said transparent photosensitive gel (13) of the type that can be activated by said solar light interposed between said sheets (11, 12), is a photovoltaic gel configured for generating electric energy from said solar light.

3. The multilayered composite sheet for transparent solar panels (10) according to claim 2, **characterized in that** it comprises electrodes immersed in said photovoltaic gel for the generation of electric current.

4. The multilayered composite sheet for transparent solar panels (10) according to claim 1, **characterized in that** said transparent photosensitive gel (13) of the type that can be activated by said solar light interposed between said sheets (11, 12), is a gel with a high thermal capacity configured for accumulating thermal energy from said solar light.

5. The multilayered composite sheet for transparent solar panels (10) according to claim 2, **characterized in that** it comprises coils positioned in said sheets (11, 12) for the passage of a fluid configured for receiving heat from said high-thermal-capacity gel.

6. The multilayered composite sheet for transparent solar panels (10) according to any of the previous claims, **characterized in that** said transparent internal sheet (12) is coloured.

7. The multilayered composite sheet for transparent solar panels (10) according to any of the previous claims, **characterized in that** the internal side of said transparent internal sheet (12) is of the mirrored type so that it not only allows the passage of light but also increases the exposure to solar light of said transparent photosensitive gel (13).

8. The multilayered composite sheet for transparent solar panels (10) according to any of the claims from 1 to 7, **characterized in that** said layers of transparent anti-yellowing material (14) and anti-hydrolysis material (15) are co-extruded to produce said sheets (11, 12).

## Patentansprüche

1. Mehrlagige Verbundstofftafel für transparente Solarmodule (10) des Typs mit einer Außentafel (11) in einem transparenten Kunststoffmaterial, das dazu geeignet ist, Sonnenlicht ausgesetzt zu werden, einer Innentafel (12) in einem transparenten Kunststoffmaterial und einer Lage aus transparentem photosensitivem Gel (13) des Typs, der durch das Sonnenlicht aktiviert werden kann, und die zwischen den Tafeln (11, 12) angeordnet ist, **dadurch gekennzeichnet, dass** sie auch eine weitere Lage aus transparentem vergilbungsbeständigem Material (14), die der Außenseite der Außentafel zugeordnet ist, sowie zwei Lagen aus transparentem Antihydrolysematerial (15) umfasst, die den Innenseiten der Tafeln (11, 12) zugeordnet sind und die Lage aus photosensitivem Gel (13) isolieren.

2. Mehrlagige Verbundstofftafel für transparente Solarmodule (10) nach Anspruch 1, **dadurch gekennzeichnet, dass** das transparente photosensitive Gel (13) des Typs, der durch das Sonnenlicht aktiviert werden kann und zwischen den Tafeln (11, 12) angeordnet ist, ein photovoltaisches Gel ist, das zur Erzeugung von elektrischer Energie aus dem Sonnenlicht konfiguriert ist.

3. Mehrlagige Verbundstofftafel für transparente Solarmodule (10) nach Anspruch 2, **dadurch gekennzeichnet, dass** sie Elektroden umfasst, die in das photovoltaische Gel für die Erzeugung von elektrischem Strom eingetaucht sind.

4. Mehrlagige Verbundstofftafel für transparente Solarmodule (10) nach Anspruch 1, **dadurch gekennzeichnet, dass** das transparente photosensitive Gel (13) des Typs, der durch das Sonnenlicht aktiviert werden kann und zwischen den Tafeln (11, 12) angeordnet ist, ein Gel mit einer hohen Wärmekapazität ist, das zum Sammeln von Wärmeenergie aus dem Sonnenlicht konfiguriert ist.

5. Mehrlagige Verbundstofftafel für transparente Solarmodule (10) nach Anspruch 2, **dadurch gekennzeichnet, dass** sie Wicklungen umfasst, die in den Tafeln (11, 12) für den Durchgang eines Fluides positioniert sind, das zur Aufnahme von Wärme von dem Gel mit hoher Wärmekapazität konfiguriert ist.

6. Mehrlagige Verbundstofftafel für transparente Solarmodule (10) nach einem der vorhergehenden Ansprüche, **dadurch gekennzeichnet, dass** die transparente Innentafel (12) farbig ist.

7. Mehrlagige Verbundstofftafel für transparente Solarmodule (10) nach einem der vorhergehenden Ansprüche, **dadurch gekennzeichnet, dass** die Innenseite der transparenten Innentafel (12) vom verspiegelten Typ ist, so dass sie nicht nur den Durchgang von Licht zulässt, sondern auch eine Sonnenlichtexposition des transparenten photosensitiven Gels (13) erhöht.

8. Mehrlagige Verbundstofftafel für transparente Solarmodule (10) nach einem der Ansprüche 1 bis 7, **dadurch gekennzeichnet, dass** die Lagen aus transparentem vergilbungsbeständigem Material (14) sowie das Antihydrolysematerial (15) gemeinsam extrudiert werden, um die Tafeln (11, 12) herzustellen.

## Revendications

1. Feuille composite multicouche pour panneaux solaires transparents (10) du type comprenant une feuille extérieure (11) en matériau plastique transparent approprié pour être exposé à la lumière solaire, une feuille intérieure (12) en matériau plastique transparent et une couche de gel photosensible transparent (13) du type qui peut être activé par ladite lumière solaire, intercalée entre lesdites feuilles (11, 12), **caractérisée en ce qu'**elle prévoit en outre une couche supplémentaire de matériau anti jaunissement transparent (14) associée à la face extérieure de ladite feuille extérieure et deux couches de matériau anti hydrolyse transparent (15) associées aux faces intérieures desdites feuilles (11, 12), isolant ladite couche de gel photosensible (13).

2. Feuille composite multicouche pour panneaux solaires transparents (10) selon la revendication 1, **caractérisée en ce que** ledit gel photosensible transparent (13) du type qui peut être activé par ladite lumière solaire, intercalé entre lesdites feuilles (11, 12), est un gel photovoltaïque configuré pour produire une énergie électrique à partir de ladite lumière solaire.

3. Feuille composite multicouche pour panneaux solaires transparents (10) selon la revendication 2, **caractérisée en ce qu'**elle comprend des électrodes noyées dans ledit gel photovoltaïque pour la production d'un courant électrique.

4. Feuille composite multicouche pour panneaux solaires transparents (10) selon la revendication 1, **caractérisée en ce que** ledit gel photosensible transparent (13) du type qui peut être activé par ladite lumière solaire, intercalé entre lesdites feuilles (11, 12), est un gel ayant une capacité thermique élevée configuré pour accumuler de l'énergie thermique provenant de ladite lumière solaire.

5. Feuille composite multicouche pour panneaux solaires transparents (10) selon la revendication 2, **caractérisée en ce qu'**elle comprend des bobines positionnées dans lesdites feuilles (11, 12) pour le passage d'un fluide configuré pour recevoir de la chaleur dudit gel à capacité thermique élevée.

6. Feuille composite multicouche pour panneaux solaires transparents (10) selon l'une quelconque des revendications précédentes, **caractérisée en ce que** ladite feuille intérieure transparente (12) est colorée,

7. Feuille composite multicouche pour panneaux solaires transparents (10) selon l'une quelconque des revendications précédentes, **caractérisée en ce que** la face intérieure de ladite feuille intérieure transparente (12) est du type réfléchissant, de sorte que, non seulement elle laisse passer la lumière, mais en plus elle augmente l'exposition à la lumière solaire dudit gel photosensible transparent (13).

8. Feuille composite multicouche pour panneaux solaires transparents (10) selon l'une quelconque des revendications 1 à 7, **caractérisée en ce que** lesdites couches de matériau anti jaunissement transparent (14) et de matériau anti hydrolyse (15) sont coextrudées pour produire lesdites feuilles (11, 12).
